# EUROPÄISCHE PATENTSCHRIFT

(11) **EP 1 102 103 B1**
(45) Veröffentlichungstag und Bekanntmachung des Hinweises auf die Patenterteilung: **26.08.2009**
(21) Anmeldenummer: 00122003.7
(22) Anmeldetag: 10.10.2000
(51) Int. Cl.: G02B 26/02, G02B 5/00

(54) **Optische Abbildungsvorrichtung, inbesondere Objektiv, mit wenigstens einer Systemblende**
Optical device, especially objective, with at least one diaphragm
Dispositif optique, en particulier objectif, avec au moins un diaphragme

(30) Priorität: 20.11.1999 DE 19955984
(43) Veröffentlichungstag der Anmeldung: 23.05.2001
(60) Teilanmeldung: 09160725.9
(73) Patentinhaber: Carl Zeiss SMT AG, 73447 Oberkochen (DE)
(72) Erfinder: Schuster, Karlheinz, 89551 Koenigsbronn (DE); Muehlbeyer, Michael, 73430 Aalen (DE); Bischoff, Thomas, 73433 Aalen (DE); Maul, Guenter, 73431 Aalen (DE); Gellrich, Bernhard, 73430 Aalen (DE); TRUNZ, Michael, D-73479 Ellwangen (DE)
(74) Vertreter: Lorenz, Werner

(56) Entgegenhaltungen:
- EP-A- 0 362 700
- DE-A- 19 833 481
- JP-A- 04 077 743
- JP-A- 07 301 845
- JP-A- 11 195 607
- US-A- 3 997 906
- US-A- 4 149 775
- US-A- 5 742 436

## Beschreibung

Die Erfindung betrifft eine optische Abbildungsvorrichtung, insbesondere Objektiv, mit wenigstens einer Systemblende, wobei eine Öffnung der Systemblende in ihrem Öffnungsdurchmesser verstellbar ist.

Allgemein bekannt ist der Einsatz von verschiedenartigen Blenden als Systemblenden in optischen Abbildungsvorrichtungen. Durch diese in ihrem Öffnungsdurchmesser veränderbare Blenden kann der Büscheldurchmesser des Strahlenganges der optischen Abbildungsvorrichtung kontinuierlich variiert werden. Dadurch kann je nach Anwendungsfall die optische Abbildungsqualität hinsichtlich z.B. der Auflösung, des Kontrastes oder der Tiefenschärfe, beeinflußt werden.

Besonders verbreitet sind sogenannte Irisblenden, die mindestens vier - meist jedoch mehr - dünne Lamellen aufweisen, welche im Allgemeinen sichelartig geformt und an einem Ende drehbar in einer festen Fassung gelagert sind. Das andere Ende ist dabei mit einem Stift als Führungseinrichtung versehen, welcher in einer Nut bzw. Kulisse eines drehbaren Rings so eingesetzt ist, daß durch das Drehen des drehbaren Rings die Lamellen in der Art bewegt werden, daß der verbleibende öffnungsdurchmesser der Blende variiert werden kann.

Bei Hochleistungsobjektiven, insbesondere für den Einsatz bei der Belichtung von lithographisch gefertigten Halbleiterbauelementen, werden immer aufwendigere Techniken zur Optimierung der Qualität der Abbildungsvorrichtung eingesetzt. So ist beispielsweise in der Japanischen Patentanmeldung JP 04077743 A ein Hochleistungsobjektiv beschrieben, bei dem zur Verbesserung der Abbildungsqualität zwei verstellbare Blenden an vershiedenen Stellen im Objektiv angeordnet sind. Die Optimierung der ausschließlich optisch wirkenden Elemente, wie z.B. Oberflächenbeschichtungen der Linsen, ist dabei technisch weitgehend ausgeschöpft, so daß weitere Steigerungen bezüglich der Abbildungsqualität nur mit sehr großem Aufwand zu realisieren sind.
Es ist daher Aufgabe der Erfindung, durch eine Optimierung der optisch-mechanischen Einrichtungen, insbesondere der Systemblenden in einer Abbildungsvorrichtung, die optischen Eigenschaften, wie z.B. den Telezentriefehler oder andere Bildfehler, der Abbildungsvorrichtung zu verbessern.

Erfindungsgemäß wird diese Aufgabe dadurch gelöst, daß die Lage der Öffnung der Systemblende in Abhängigkeit von dem öffnungsdurchmesser der Systemblende festgelegt ist.

Sehr komplexe mathematische bzw. optische Berechnungen aus dem Bereich der Optik haben in überraschender Weise gezeigt, daß eine Veränderung der Lage der Systemblende in Abhängigkeit ihres Öffnungsdurchmessers einen Qualitätsgewinn bezüglich der Abbildungsqualität der optischen Abbildungsvorrichtung ermöglicht. Dabei ist sicherlich die Veränderung der axialen Lage der Systemblende deren bevorzugte Bewegung, es sind jedoch auch eine Seitwärts- oder eine Kippbewegung oder beliebige Kombinationen der drei oben genannten Bewegungen denkbar.

Die Vorzüge und vorteilhaften Verbesserungen, welche durch die erfindungsgemäße Systemblende erreicht werden können, bieten bei den weitgehend ausgereizten Optimierungen der Linsensysteme eine vergleichsweise einfache und günstige Möglichkeit einen Zugewinn an Abbildungsqualität zu erzielen.

Insbesondere im Bereich der Fertigung von Halbleiterbauelementen bzw. Computerchips müssen besonders hohe Anforderungen an die Abbildungsqualität und das Auflösungsvermögen der Abbildungsvorrichtungen gestellt werden. Die Abbildungsvorrichtungen werden nämlich dazu genutzt, kleinste, mechanisch gerade noch herzustellende Vorlagen für ein Chip-Layout in verkleinerter Form auf einem mit einer lichtempfindlichen Schicht beschichteten Siliziumwafer abzubilden. Durch verschiedene Atzverfahren, welche der Siliziumwafer durchläuft, werden aus den so belichteten Mikrostrukturen dann die Schaltkreisen des Computerchips bzw. des Halbleiterbauelements. Kleinste durch die Abbildungsvorrichtung verursachte Abweichungen und Verzerrungen in der Abbildung der Vorlage für das Chip-Layout auf dem Siliziumwaver können bei den Mikrostrukturen des fertigen Computerchips bereits zu Leitungsberührungen, Kurzschlüssen oder anderen elektronischen Fehlfunktionen führen. Daher bringen speziell bei den in der Fertigung von Computerchips und Halbleiterbauelementen eingesetzten Abbildungsvorrichtungen schon kleinste Qualitätsgewinne große Vorteile, weshalb hier die optischen Vorzüge der in ihrer axialen Lage verstellbaren Systemblende voll zur Geltung kommen.

In einer besonders günstigen Ausführungsform der Erfindung ist die Veränderung der axialen Lage der Systemblende in Abhängigkeit ihres Öffnungsdurchmessers in einem konstruktiv vergleichsweise einfachen Aufbau gelöst. Die Systemblende weist dabei wenigstens zwei mit einem axialen Abstand zueinander angeordnete Blenden auf, wobei in Abhängigkeit des Öffnungsdurchmessers der Systemblende eine jeweils andere Blende optisch aktiv ist. Optisch aktiv bedeutet dabei, daß die optisch aktive Blende bzw. deren optisch wirksame Kante für die seitliche Begrenzung des Strahlenbüschels in der Abbildungsvorrichtung sorgt.

Diese erfindungsgemäße Doppel- bzw. Mehrfachblende bietet den Vorteil, daß hier ohne aufwendige Mechanik zur Verstellung der axialen Lage der erfindungsgemäße Effekt erreicht werden kann. Dabei sind die wenigstens zwei Blenden so angeordnet, daß sie in wenigstens zwei zu der optischen Achse der Systemblende axial verschiedenen Ebenen liegen. Dadurch das jeweils nur eine der Blenden optisch aktiv ist kann je nach Öffnungsdurchmesser eine andere Ebene und somit eine andere axiale Lage der Systemblende realisiert werden, wodurch bereits ein guter optischer Effekt erreicht wird. Kritisch ist dabei der Bereich, wenn sich zwei der Blenden "überholen", also wenn bei einem bestimmten Öffnungsdurchmesser der Systemblende kurzzeitig die optisch wirksamen Kanten von zwei der Blenden gleichzeitig optisch aktiv sind. Um Unschärfeeffekte zu vermeiden, erfordert dies eine sehr präzise Mechanik, wie z.B. die Lagerung der Blenden bzw. derer Einzelteile mittels spielfrei vorgespannten Wälzlagerelementen.

In einer weiteren sehr günstigen Ausführungsform der Erfindung die nicht Gegenstand der Patentansprüche ist, weist die Systemblende Lamellen auf, welche zwischen zwei rotatorisch relativ zueinander beweglichen Blendenböden angeordnet sind, wobei wenigstens einer der Blendenböden rotatorisch bewegbar ist und wobei die Einheit aus den Lamellen und den zwei Blendenböden in axialer Richtung bewegbar ist.

Diese erfindungsgemäße Lösungsvariante der Aufgabe kommt mit nur einer einzigen Blende aus. Zusätzlich zu den wenigstens zwei diskreten axialen Ebenen der oben beschriebenen Ausführungsform bietet sich hier der Vorteil, daß sämtliche axiale Zwischenebenen verfügbar sind. Je nach Öffnungsdurchmesser der Blende kann diese nämlich ihre axiale Lage verändern, da die Einheit aus Lamellen und relativ zueinander beweglichen Blendenböden durch mechanische Führungselemente in der Art gekoppelt ist, daß die gewünschte Verstellung der axialen Lage der Blende in Abhängigkeit des Öffnungsdurchmessers erzielt werden kann.

Dieser konstruktive Aufbau weist den besonderen Vorteil auf, daß eine Führungsnut, welche die rotatorische und die axiale Bewegungen der beiden Blendenböden zueinander koordiniert, in beliebiger geometrischer Form ausgeführt sein kann. Je nach Form der Führungsnut können dabei verschiedene mathematische Abhängigkeiten zwischen der rotatorischen Bewegung und damit der Veränderung des Öffnungsdurchmessers und der axialen Bewegung der Systemblende realisiert werden.

In einer weiteren sehr günstigen Variante der Erfindung die ebenfalls nicht Gegenstand der Patentansprüche ist, ist die Blende ebenfalls mittels Lamellen ausgebildet, wobei die Lamellen und die den Lamellen zugewandten Oberflächen der Blendenböden über den wenigstens annähernd größten Teil des Öffnungsdurchmessers der Systemblende in einem Winkel zu der optischen Achse der Systemblende angeordnet sind.

Dadurch kann die optisch wirksame Kante der Blende, je nach geometrischer Gestalt der Lamellen bzw. der den Lamellen zugewandten Oberflächen der Blendenböden, auf z.B. einer Kegelmantelfläche oder auf der Mantelfläche einer Kugelkalottenform verfahren werden. Die rotationssymmetrisch zu der optischen Achse der Systemblende angeordneten Lamellen bewegen sich, z.B. beim Schließen der Systemblende, dann in einer linearen oder halbkreisförmigen Abhängigkeit zwischen dem Öffnungdurchmesser und der axialen Lage in den Lichtweg der Abbildungsvorrichtung.

Weitere vorteilhafte Ausgestaltungen der Erfindung ergeben sich aus den übrigen Unteransprüchen und aus den anhand der Zeichnungen nachfolgend beschriebenen Ausführungsbeispielen.

Es zeigt:
- Figur 1: einen Querschnitt einer Systemblende einer optischen Abbildungsvorrichtung mit mehreren übereinander liegen- den Blenden;
- Figur 2: einen Querschnitt einer Systemblende mit einer in axia- ler Richtung beweglichen Baueinheit aus Lamellen und Blendenböden; und
- Figur 3: einen Querschnitt einer Systemblende mit einer Anord- nung der Lamellen in einem Winkel zu der optischen Ach- se der Systemblende.

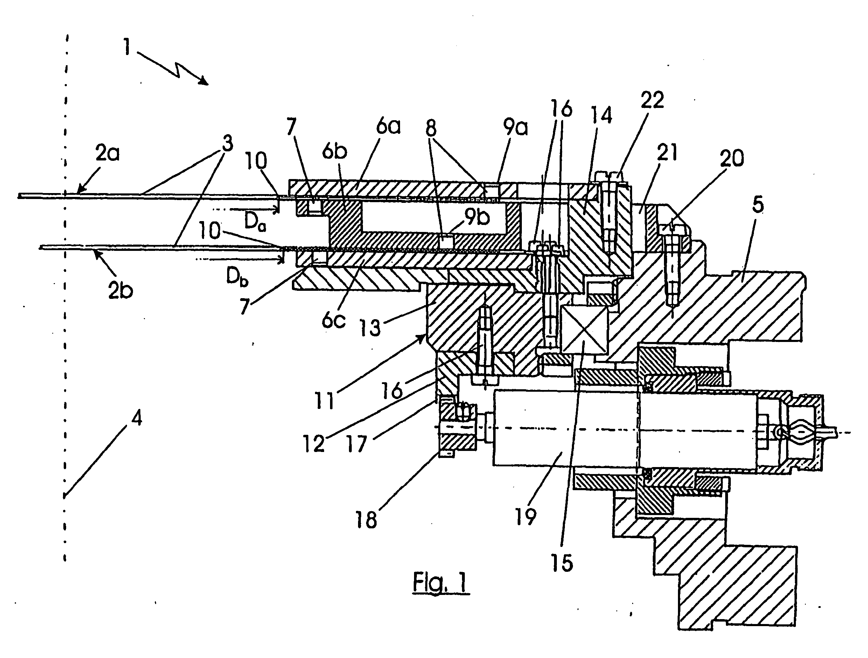

In Fig. 1 ist ein Querschnitt durch eine Systemblende 1 dargestellt, wobei die Systemblende 1 zwei einzelne Blenden 2a, 2b bzw. Irisblenden 2a, 2b aufweist. Diese Irisblenden 2a, 2b sind aus Lamellen 3 aufgebaut, welche wenigstens annähernd senkrecht zur optischen Achse 4 der Systemblende 1 angeordnet sind. Die Systemblende 1 ist in einer Fassung 5 gelagert, wobei die Fassung 5 fest mit einer Ummantelung eines Objektives (nicht dargestellt) verbunden ist.

In einer nicht dargestellten Ausführungsform der Systemblende 1 kann diese neben den zwei einzelnen Blenden 2a, 2b noch eine weitere Blende aufweisen. Insbesondere kann es sich bei dieser weiteren Blende um eine Festblende bzw. eine fest eingebaute Scheibe handeln, welche in einem axialen Abstand zu den beiden Irislenden 2a, 2b in der Systemblende 1 angebracht ist.

Die Lamellen 3 der beiden Blenden 2a, 2b liegen mit ihren einem jeweiligen Öffnungsdurchmesser Dₐ, D_{b} abgewandten Seiten zwischen zwei jeweils relativ zueinander beweglichen Blendenböden 6a, 6b, 6c. Dabei sind die Lamellen 3 durch spielfrei vorgespannte Lagereinrichtungen 7 in jeweils einem der mit ihnen zusammenwirkenden Blendenböden 6b, 6c gelagert sind. Im Bereich des jeweils anderen Blendenbodens 6a, 6b weist jede der Lamellen 3 eine Führungseinrichtung 8 auf. Die Führungseinrichtungen 8 werden in einer in den jeweiligen Blendenboden 6a, 6b eingearbeiteten Kulisse 9a, 9b geführt, wobei auch hier eine spielfreie Vorspannung der Führungseinrichtungen 8 gegenüber der Kulisse 9a, 9b vorzusehen ist.

Die spielfreie Vorspannung der Lager- bzw. Führungseinrichtungen 7 bzw. 8 kann z.B. so ausgebildet sein, daß jede der Lamellen 3 durch Torsionsfedern (nicht dargestellt) in der Art vorgespannt wird, daß sie spielfrei in der Lagereinrichtung 7, z.B. einem Wälzlager, und der jeweiligen Kulisse 9a, 9b aufgenommen ist.

Durch eine rotatorische Relativbewegung der Blendenböden 6a, 6b bzw. 6b, 6c zueinander werden die mit den Lagereinrichtungen 7 gelagerten Lamellen 3, durch die in den verschiedenartig ausgebildeten Kulissen 9a, 9b laufenden Führungseinrichtungen 8, auf einer für die jeweilige Lamelle 3 vorgegebenen Bahn bewegt. Optisch wirksame Kanten 10a, 10b der Lamellen 3 ändern dadurch ihren öffnungsdurchmesser Dₐ, D_{b}. Üblicherweise sind die Kulissen 9a, 9b der Irisblenden 2a, 2b in der Art ausgeführt, daß die Öffnung der Systemblende 1 bzw. jeder der Irisblenden 2a, 2b sich in der Art eines annähernd kreisförmigen Vielecks vergrößern bzw. verkleinern läßt.
Die Ausgestaltung der Kulissen 9a, 9b der hier vorliegenden Systemblende 1 muß dabei jeweils eine andere geometrische Kurve aufweisen, da es erforderlich ist, daß in Abhängigkeit des Öffnungsdurchmessers einmal die eine Irisblende 2a, ein anderes Mal die andere Irisblende 2b bzw. deren jeweilige optisch wirksame Kante 10a, 10b optisch aktiv ist. Dies bedeutet, daß die optisch nicht aktive Irisblende 2a bzw. 2b einen größeren Öffnungsdurchmesser Dᵤ bzw. D_{b} aufweisen muß als die jeweils optisch aktive Irisblende 2b bzw. 2a.

Im Fall, daß die Systemblende 1 eine dritte Festblende (nicht dargestellt) aufweist, kann darüber hinaus noch der Fall auftreten, daß keine der beiden Irisblenden 2a bzw. 2b optisch aktiv ist, sondern nur die in einem axialen Abstand zu den Irisblenden 2a, 2b angeordnete Festblende.

In dem in Fig. 1 dargestellten Ausführungsbeispiel sind zwei der Blendenböden 6a, 6c fest, insbesondere verdrehfest mit einem Tellerrad 11 verbunden. Das aus mehreren Einzelelementen 12, 13, 14 aufgebaute Tellerrad 11 ist mit einer wälzlagerung 15 in der Fassung 5 gelagert und die Einzelelemente 12, 13, 14 des Tellerrads 11 sind durch mehrere Befestigungselemente 16 miteinander verbunden. Außerdem weist eines der Einzelelemente 12 des Tellerrads 11 eine Verzahnung 17 auf und läßt sich durch ein Ritzel 18 in eine zu der optischen Achse 4 der Systemblende 1 rotatorische Bewegung versetzen. Im dargestellten Ausführungsbeispiel dient eine Antriebseinheit 19, hier ein Elektromotor 19, dazu, das Ritzel 18 und damit das Tellerrad 11 und die mit ihm verbundenen Blendenböden 6a, 6c um die optische Achse 4 der Systemblende 1 zu drehen. Die Antriebseinheit 19 ist dabei fest mit der Fassung 5 verbunden. Der zwischen den beiden Irisblenden 2a, 2b gelegene Blendenboden 6b ist mittels eines Befestigungselementes 20 ebenfalls an der Fassung 5 fixiert. Dabei ist eines der Einzelelemente 14 des Tellerrads 11 durch eine oder mehrere Aussparungen 21 in dem zwischen den beiden Irisblenden 2a, 2b liegenden Blendenboden 6b durchgeführt. Durch ein weiteres Befestigungselement 22 ist der Blendenboden 6a an dem Einzelelement 14 des Tellerrads 11 befestigt.

Werden nun durch die Antriebseinheit 19 das Tellerrad 11 und die beiden Blendenböden 6a, 6c gedreht, so bleibt der über Befestigungselement 20 mit der Fassung 5 verbundene Blendenboden 6b ortsfest und es kommt zu einer Relativbewegung zwischen den Blendenböden 6a, 6c und dem Blendenboden 6b. Durch diese Relativbewegung werden die in den Kulissen 9a, 9b geführten Lamellen 3 bewegt und der Öffnungsdurchmesser Dₐ bzw. D_{b} der Systemblende 1 bzw. der beiden Irisblenden 2a, 2b ändert sich.

Durch die geometrische Ausgestaltung der Kulissen 9a, 9b kann nun erreicht werden, daß die für den jeweiligen Öffnungsdurchmesser Dₐ, D_{b} der Systemblende 1 besser geeignete Irisblende 2a, 2b optisch aktiv ist. Aus den beiden diskreten axialen Stellungen der Irisblenden 2a, 2b wird also die optisch jeweils besser passende ausgewählt, wobei dazu nur eine einzige Drehbewegung ausgeführt und angesteuert werden muß. Es dürfte dabei klar sein, daß dies eine stetige oder zumindest annähernd stetige Abhängigkeit der axialen Lage der Blende 2a, 2b von deren Öffnungsdurchmesser Dₐ, D_{b} erforderlich macht, da die als mechanische Führungen dienenden Kulissen 9a, 9b nur so gestaltet werden können, daß zuerst die eine, dann die andere Irisblende 2a, 2b optisch aktiv ist.

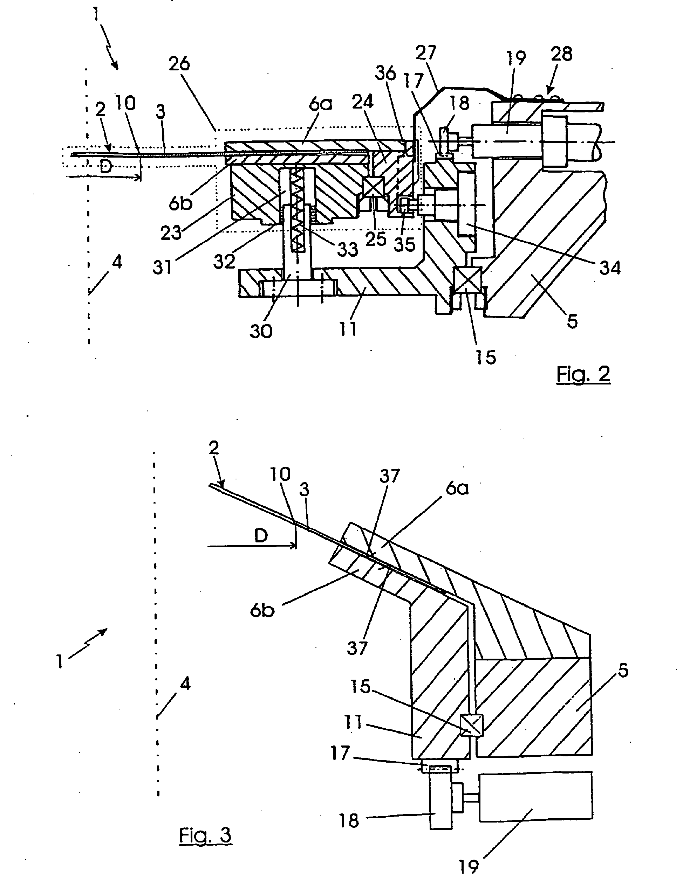

In Fig. 2 ist eine weitere, hier nicht beanspruchte Ausgestaltung der Systemblende erkennbar. Diese weist lediglich eine Irisblende 2 auf. Auch hier sind die Lamellen 3 der Irisblende 2 zwischen zwei Blendenböden 6a, 6b bzw. Nutenring 6a und Blendenboden 6b angeordnet. Die Lagerungseinrichtungen 7 und die Führungseinrichtungen 8 bzw. die Kulisse 9 (in Fig. 2 nicht dargestellt) existieren hier ebenfalls, allerdings nur je einmal pro Lamelle 3. Die weiteren Elemente in Fig. 2 sind prinzipiell den in Fig. 1 erläuterten in Aufbau und Funktionsweise vergleichbar.

So ist auch in Fig. 2 die der Fassung 5 erkennbar, in welcher die Antriebseinheit 19 mit dem Ritzel 18 aufgenommen ist. Das Ritzel 18 treibt über die Verzahnung 17 ein hier einteilig ausgebildetes Tellerrad 11 an. Das Tellerrad 11 ist mit der Wälzlagerung 15 in der Fassung 5 gelagert.

Die Irisblende 2 bildet zusammen mit dem Nutenring 6a und dem Blendenboden 6b, einem Innenring 23, einem Außenring 24 und einer Wälzlagerung 25 eine Baueinheit 26. In der Baueinheit 26 ist der Blendenboden 6b mit dem Innenring 23 verbunden, der Nutenring 6a ist mit dem Außenring 24 verbunden. Der Innenring 23 ist gegenüber dem Außenring 24 drehbeweglich ausgeführt, wobei zwischen dem Innenring 23 und dem Außenring 24 die Wälzlagerung 25 angeordnet ist. Eine Relativbewegung der beiden Blendenböden 6a, 6b zueinander bedeutet also auch, daß es zu einer Relativbewegung des Innenrings 23 gegenüber dem Außenring 24 kommt.

Der Außenring 24 und damit auch der eine Blendenboden 6a wird über Halteelemente 27 verdrehsicher gegenüber der Fassung 5 gehalten. Die Halteelemente 27 können z.B. als Blechlaschen 27 ausgebildet sein, die an der Fassung 5 über Befestigungselemente 28 angebracht sind. An dem Außenring 24 kommen die Blechlaschen 27 dann zwischen zwei Vorsprüngen 29 zu liegen, welche eine axiale Bewegung des Außenrings 24 erlauben, ein Verdrehen jedoch verhindern. Idealerweise sind dabei drei bis sechs Halteelemente 27 über den Umfang der Systemblende 1 verteilt.

Das Tellerrad 11 weist einen oder mehrere Mitnehmerzapfen 30 auf, wobei diese gegebenenfalls über den Umfang der Systemblende 1 gleichmäßig verteilt sind. Die Mitnehmerzapfen 30 greifen dabei in jeweils eine Aussparung 31 in dem Innenring 23 ein, so daß sich eine durch die Antriebseinrichtung 19 erzeugte Rotationsbewegung des Tellerrads 11 auf den Innenring 23 und damit auf den Blendenboden 6b überträgt. Die Mitnehmerzapfen 30 sind in den jeweiligen Aussparungen 31 durch Wälzkörper 32 in der Art gelagert, daß eine reibungsarme und weitgehend spielfreie axiale Relativbewegung des Innenrings 23 zu dem Mitnehmerzapfen 30 und damit auch zu dem Tellerrad 11 möglich ist.

Zusätzlich weist die Verbindung des Mitnehmerzapfens 30 und des Innenrings 23 ein Federelement 33 auf, welches in der Art ausgeführt ist, daß es die Baueinheit 26 in einer axialen Mittelstellung hält, so daß die axiale Bewegung der Baueinheit 26 gegenüber dem Tellerrad 11 in beiden Richtungen mit vergleichsweise geringen Kräften möglich ist.

Weiterhin weist das Tellerrad 11 einen fest mit ihm verbundenen Führungszapfen 34 auf. Die Spitze des Führungszapfens 33 ist mit einem Wälzlager 35 versehen, welches in einer Führungsnut 36 in dem Außenring 24 läuft. Die Führungsnut 36 und das Wälzlager 35 des Führungszapfens 34 bilden dabei die mechanische Kopplung der rotatorischen Bewegung des Tellerrades 11 mit der axialen Bewegung der Baueinheit 26.

Wenn nun das Tellerrad 11 durch das Ritzel 18 bzw. die Antriebseinheit 19 gedreht wird, bleibt der durch die Halteelemente 27 verdrehfest gehaltene Außenring 24 gegenüber dem durch die Mitnehmerzapfen 30 des Tellerrades 11 mitgedrehten Innenring 23 in radialer Drehrichtung unbeweglich. Durch die mit dem Wälzlager 35 bzw. dem Führungszapfen 34 korrespondierende Führungsnut 36 wird allerdings eine axiale Relativbewegung der Baueinheit 26 gegenüber dem Tellerrad 11 erzwungen. Bei gegenüber der Fassung 5 axial feststehendem Tellerrad 11 bedeutet dies, daß sich der Außenring 24 gegenüber der Fassung 5 axial verschiebt. Durch das Wälzlager 25 wird diese axiale Bewegung auch auf den Innenring 23 übertragen, es verschiebt sich die komplette Baueinheit 26 in axialer Richtung. Gleichzeitig kommt es durch die Mitnehmerzapfen 30 zu der Drehbewegung des Innenrings 23 und des Blendenbodens 6b, wodurch sich die Irisblende 2 öffnet bzw. schließt. Durch die Drehbewegung des Tellerrads 11 wird also gleichzeitig der Öffnungsdurchmesser D der Systemblende 1 und die axiale Lage der Baueinheit 26 bzw. der Irisblende 2 in Abhängigkeit voneinander verändert.

Je nach Form und Ausführung der Führungsnut 36 läßt sich die optisch wirksame Kante 10 der Irisblende 2 auf einer annähernd beliebigen Kurve bewegen. In dem in Fig. 2 dargestellten Ausführungsbeispiel ist also die Abhängigkeit zwischen Öffnungsdurchmesser D und axialer Lage der optischen wirksamen Kante 10 der Systemblende 1 im Rahmen der Fertigungsmöglichkeiten für die Führungsnut 36 bzw. nach den gegebenen, optischen Anforderungen wählbar, wobei sowohl optisch als auch fertigungstechnisch im Allgemeinen nur stetige Kurven sinnvoll sind.

Fig. 3 zeigt eine Prinzipskizze einer weiteren, ebenfalls nicht beanspruchten Ausführungsform der Systemblende 1. Hier sind ebenfalls die in den vorhergehenden Figuren bereits beschriebenen Elemente erkennbar. Wobei der eine Blendenboden 6a fest mit der äußeren Fassung 5 verbunden ist. Der andere Blendenboden 6b ist über die Wälzlagerung 15 in der Fassung 5 gelagert. Ein Teil des Blendenbodens 6b stellt gleichzeitig das Tellerrad 11 dar und läßt sich über die Antriebseinheit 19 mit dem Ritzel 18 rotatorisch bewegen. Über die in den vorhergehenden Figuren bereits beschriebenen Lagereinrichtungen 7, Führungseinrichtungen 8 und Kulissen 9 (hier nicht dargestellt) werden die Lamellen 3 der Irisblende 2 bewegt.

Die Besonderheit dieser Ausführungsform liegt darin, daß die Lamellen 3 der Blende 2 in der Art angeordnet sind, daß jede einzelne in einem spitzen Winkel zu der optischen Achse der Systemblende 1 angeordnet ist. Die optisch wirksamen Kanten 10 der Lamellen 3 bzw. der Irisblende 2 bewegt sich dann auf der Mantelfläche z.B. eines Kegels oder eines Rotationsparaboloids. Je nach der Vorgabe der Mantelfläche läßt sich hier die axiale Lage der optisch wirksamen Kante 10 der Irisblende 2 in Abhängigkeit von ihrem Öffnungsdurchmesser D vorgeben.

Dabei sind sowohl die Lamellen 3 als auch die den Lamellen 3 zugewandten Oberflächen 37 der Blendenböden 6a, 6b in der Form der gewünschten Mantelfläche ausgebildet. Die Mantelfläche sollte dabei immer die Mantelfläche eines zu der optischen Achse 4 der Systemblende 1 rotationssymmetrischen Körpers sein. Die optisch wirksamen Kanten 10 der Lamellen 3 bewegen sich dann auf dieser jeweiligen Fläche.

## Patentansprüche

1. Optische Abbildungsvorrichtung, insbesondere Objektiv, mit wenigstens einer Systemblende (1), die wenigstens zwei mit einem axialen Abstand zueinander angeordnete Blenden (2a,2b) aufweist, wobei die Lage und der Durchmesser der Öffnung der Systemblende (1) **dadurch** verstellbar ist, dass in Abhängigkeit des Öffnungsdurchmessers (D bzw. Dₐ, D_{b}) der Systemblende (1) jeweils eine andere Blende (2a,2b) ein Strahlenbüschel der Abbildungsvorrichtung begrenzt und wobei sich zwischen den wenigstens zwei Blenden (2a,2b) keine optischen Elemente befinden.

2. Optische Abbildungsvorrichtung nach Anspruch 1, **dadurch gekennzeichnet, dass** die Systemblende (1) gegeneinander beweglich ausgebildete Lamellen (3) aufweist, wobei zumindest Teile der Lamellen (3) zwischen zwei relativ zueinander beweglichen Blendenböden (6a,6b bzw. 6b,6c) angeordnet sind, und wobei die Blendenböden (6a,6b,6c) Führungseinrichtungen (8) aufweisen, durch welche jede einzelne Lamelle (3) auf einer vorgegebenen Bahn führbar ist.

3. Optische Abbildungsvorrichtung nach Anspruch 2, **dadurch gekennzeichnet, dass** die Blendenböden (6a,6b,6c) durch eine Antriebseinrichtung (19) relativ gegeneinander bewegbar sind, wobei jede Lamelle (3) durch eine spielfrei vorgespannte Führungseinrichtung (7) in jeweils einem der Blendenböden (6a bzw. 6b) gelagert und durch eine spielfrei vorgespannte Lagereinrichtung in dem jeweils anderen Blendenboden (6b bzw. 6c) geführt ist.

4. Optische Abbildungsvorrichtung nach Anspruch 2 oder 3, **dadurch gekennzeichnet, dass** die Lamellen (3) der Systemblende (1) wenigstens annähernd senkrecht zur optischen Achse.(4) angeordnet sind.

5. Optische Abbildungsvorrichtung nach einem der Ansprüche 2 bis 4, **dadurch gekennzeichnet, dass** die Blenden (2a,2b) jeweils die Lamellen (3) aufweisen, wobei Teile der Lamellen (3) zwischen den jeweils zwei relativ zueinander beweglichen Blendenböden (6a,6b) angeordnet sind, und einer der Blendenböden (6a bzw. 6b) die Lagereinrichtungen (7) der Lamellen (3) der einen Blende (2a) und die Lagereinrichtungen (7) oder die Führungseinrichtungen (8) der Lamellen (3) der anderen Blende (2b) aufweist.

6. Optische Abbildungsvorrichtung nach einem der Ansprüche 2 bis 5, **dadurch gekennzeichnet, dass** die Lamellen (3) und die den Lamellen (3) zugewandten Oberflächen (37) der Blendenböden (6a, 6b) über den wenigstens annähernd größten Teil des Öffnungsdurchmessers (D) der Systemblende (1) in einem spitzen Winkel zu der optischen Achse (4) der Systemblende (1) angeordnet sind.

7. Verwendung einer optischen Abbildungsvorrichtung nach einem der Anspruche 1 bis 6 als Hochleistungsobjektiv für den Einsatz bei der Belichtung von lithographisch gefertigten Halbleiterbauelementen.

## Claims

1. Optical imaging device, in particular objective, having at least one system diaphragm (1) which comprises at least two diaphragms (2a, 2b) arranged at an axial distance from one another, wherein the position and the diameter of the aperture of the system diaphragm (1) can be adjusted by having a different diaphragm (2a, 2b) respectively delimit a ray pencil of the imaging device as a function of the aperture diameter (D and respectively Dₐ, D_{b}) of the system diaphragm (1) and wherein there are no optical elements between the at least two diaphragms (2a, 2b).

2. Optical imaging device according to Claim 1, **characterised in that** the system diaphragm (1) comprises lamellae (3) designed so that they are mutually displaceable, at least parts of the lamellae (3) being arranged between two diaphragm bases (6a, 6b and respectively 6b, 6c) which can be displaced relative to one another, and the diaphragm bases (6a, 6b, 6c) comprising guide instruments (8) by which each individual lamella (3) can be guided on a predetermined path.

3. Optical imaging device according to Claim 2, **characterised in that** the diaphragm bases (6a, 6b, 6c) can be mutually displaced by a drive instrument (19), each lamella (3) being supported respectively in one of the diaphragm bases (6a and respectively 6b) by a guide instrument (7) prestressed without play and being guided in the other respective diaphragm base (6b and respectively 6c) by a supporting instrument prestressed without play.

4. Optical imaging device according to Claim 2 or 3, **characterised in that** the lamellae (3) of the system diaphragm (1) are arranged at least approximately perpendicular to the optical axis (4).

5. Optical imaging device according to one of Claims 2 to 4, **characterised in that** the diaphragms (2a, 2b) respectively comprise the lamellae (3), parts of the lamellae (3) being arranged between the two respective diaphragm bases (6a, 6b) which are displaceable relative to one another, and one of the diaphragm bases (6a and respectively 6b) comprising the supporting instruments (7) of the lamellae (3) of one diaphragm (2a) and the supporting instruments (7) or the guide instruments (8) of the lamellae (3) of the other diaphragm (2b).

6. Optical imaging device according to one of Claims 2 to 5, **characterised in that** the lamellae (3), and those surfaces (37) of the diaphragm bases (6a, 6b) which face towards the lamellae (3), are arranged at an acute angle with respect to the optical axis (4) of the system diaphragm (1) over at least approximately the majority of the aperture diameter (D) of the system diaphragm (1).

7. Use of an optical imaging device according to one of Claims 1 to 6 as a high-performance objective to be employed for the exposure of lithographically fabricated semiconductor components.

## Revendications

1. Dispositif de reproduction optique, en particulier objectif, comprenant au moins un diaphragme-système (1) qui comporte au moins deux diaphragmes (2a, 2b) disposés à une certaine distance axiale l'un de l'autre, dans lequel la position et le diamètre de l'ouverture du diaphragme-système (1) peuvent être réglés de telle manière, qu'en fonction du diamètre de l'ouverture (D ou Dₐ, D_{b}) du diaphragme-système (1), ce soit l'un ou l'autre diaphragme (2a, 2b) qui limite un faisceau de rayons du dispositif de reproduction, et dans lequel aucun élément optique ne se trouve entre les au moins deux diaphragmes (2a, 2b).

2. Dispositif de reproduction optique selon la revendication 1, **caractérisé en ce que** le diaphragme-système (1) comporte des lamelles (3) mobiles les unes par rapport aux autres, au moins des parties des lamelles (3) étant disposées entre deux plateaux de diaphragmes (6a, 6b, ou 6b, 6c) mobiles l'un par rapport à l'autre, et les plateaux de diaphragmes (6a, 6b, 6c) comportant des dispositifs de guidage (8) au moyen desquels chaque lamelle distincte (3) peut être guidée sur une trajectoire prédéterminée.

3. Dispositif de reproduction optique selon la revendication 2, **caractérisé en ce que** les plateaux de diaphragmes (6a, 6b, 6c) peuvent être déplacés l'un par rapport à l'autre par un dispositif d'entraînement (19), chaque lamelle (3) étant guidée par un dispositif de guidage précontraint sans jeu (7) prévu dans l'un des plateaux de diaphragmes (6a ou 6b) et par un dispositif de palier précontraint sans jeu dans l'autre plateau de diaphragme (6b ou 6c).

4. Dispositif de reproduction optique selon la revendication 2 ou 3, **caractérisé en ce que** les lamelles (3) du diaphragme-système (1) sont disposées au moins à peu près perpendiculairement à l'axe optique (4).

5. Dispositif de reproduction optique selon l'une des revendications 2 à 4, **caractérisé en ce que** les diaphragmes (2a, 2b) comportent tous des lamelles (3), des parties des lamelles (3) étant disposées entre deux plateaux de diaphragme (6a, 6b) mobiles l'un par rapport à l'autre, et un des plateaux de diaphragme (6a ou 6b) étant pourvu des dispositifs d'articulation (7) des lamelles (3) d'un diaphragme (2a) et des dispositifs d'articulation (7) ou des dispositifs de guidage (8) des lamelles (3) de l'autre diaphragme (2b.).

6. Dispositif de reproduction optique selon l'une des revendications 2 à 5, **caractérisé en ce que** les lamelles (3) et les surfaces (37) des plateaux de diaphragmes (6a, 6b) qui sont dirigées vers les lamelles (3) sont disposées à angle aigu par rapport à l'axe optique (4) du diaphragme-système (1) sur au moins à peu près la plus grande partie du diamètre de l'ouverture (D) du diaphragme-système (1).

7. Emploi d'un dispositif de reproduction optique selon l'une des revendications 1 à 6 comme objectif à hautes performances destiné à être utilisé pour l'illumination de composants à semi-conducteur fabriqués par lithographie.
